# EUROPEAN PATENT APPLICATION

(11) **EP 4 513 132 A1**
(43) Date of publication of application: **26.02.2025**
(21) Application number: 24186858.7
(22) Date of filing: 05.07.2024
(51) Int. Cl.: G01B 5/00, G01B 11/25

(54) **SENSING DEVICE AND METROLOGY SYSTEM INCORPORATING SUCH A SENSING DEVICE**

(30) Priority: 21.08.2023 US 202318236205
(71) Applicant: DWFRITZ Automation, LLC, Wilsonville, OR 97070 (US)
(72) Inventor: Grohs, Levi, Wilsonville (US); Gundersen, James, Wilsonville (US); Tippanna, Raghavendra, Wilsonville (US); Headrick, Garrett, Wilsonville (US); Davis, Keith, Wilsonville (US); VanderGiessen, Clint, Wilsonville (US); Heneghan, Brian, Wilsonville (US)
(74) Representative: Sandvik

(57) **Abstract**

Disclosed is a sensing device (100) for a metrology system (160). The sensing device (100) has a measurement region (160) and comprises a body (105). The body (105) comprises at least one light source (110) adapted to emit a light onto a workpiece (150), and at least one sensor (120) adapted to receive light from the light source (110) after it has been reflected by the workpiece (150). The sensing device further comprises at least one heat exchanger (130) comprising an inlet (135) and an outlet (137) for exchanging heat between the measurement region (160) and an outside of the measurement region (160).

## Description

### Technical field

The present disclosure relates generally to a sensing device for a metrology system, and a metrology system incorporating such a device. The disclosure further relates to a method for controlling the temperature in a metrology system.

### Background

Today, measurement of parts using advanced metrology systems is becoming an increasingly important part of manufacturing.

Contactless inspection of parts is an area within metrology that is showing great results and which can greatly reduce the time needed for inspecting a part compared with measurement systems requiring contacting the workpiece with e.g. a probe. In contactless metrology systems, light beams such as lasers are often used for measuring, such that a laser beam is directed at a workpiece and the reflection of the laser beam is received by a sensor.

As the complexity of the manufactured parts increase, and as technology develops, it becomes increasingly important to minimize measurement errors as well as increase the measuring capabilities. This is especially true in technology areas with very high requirements on accuracy and repeatability.

Thus, any improvement to a contactless metrology system that improves accuracy or increases repeatability, e.g. by decreasing the variance between measurements, is a welcome benefit.

Consequently, there exists a need for improvement when it comes to contactless metrology systems.

### Summary

It is an object of the invention to address at least some of the problems and issues outlined above. An object of embodiments of the invention is to provide a sensing device for a metrology system comprising a heat exchanger, such that heat may be transported away from a measurement region of the sensing device in order to improve the performance of the sensing device and/or of the metrology system as a whole.

According to an aspect, a sensing device for a metrology system is provided, the sensing device having a measurement region and comprising a body. The body comprises at least one light source adapted to emit a light onto a workpiece and at least one sensor adapted to receive light from the light source after it has been reflected by the workpiece. The sensing device further comprises at least one heat exchanger comprising an inlet and an outlet for exchanging heat between the measurement region and an outside of the measurement region.

According to another aspect, metrology system for inspection of a three-dimensional workpiece is provided. The metrology system comprises an enclosure, which contains at least one sensing device according to embodiments described herein, wherein the heat exchanger of the sensing device is adapted to exchange heat between an inside the enclosure and an outside of the enclosure.

According to another aspect, a method for improving the performance of a metrology system according to embodiments herein is provided. The method comprises exchanging heat between a measurement region of a sensing device inside of the enclosure and an outside of the enclosure.

### Brief description of drawings

The solution will now be described in more detail by means of exemplary embodiments and with reference to the accompanying drawings, in which:
Fig. 1 is a view of a sensing device according to an embodiment.
Fig. 2 shows another view of a sensing device, according to an embodiment.
Fig. 3 shows a sensing device according to another embodiment.
Fig. 4 is a view of a metrology system comprising three sensing devices, according to an embodiment.
Fig. 5 schematically shows steps of a method according to an embodiment.

### Detailed description

Briefly described, the present disclosure relates to a sensing device for a metrology system. The sensing device comprises a body with at least one light source such as a laser, for example a laser profiler, which is adapted to measure a workpiece by emitting a beam of light on it and then receiving the light beam with a sensor after it has been reflected by the workpiece. The sensing device further comprises one heat exchanger, either attached to or incorporated into the body. The heat exchanger may be a fluid heat exchanger using air as cooling fluid.

It has been discovered that the performance of various components in a contactless metrology system, including sensors and light sources, can be negatively impacted from too much heat. This is at least partly due to that the heat distorts the light beam used to measure a workpiece, but the heat may negatively impact other components in the system as well. However, the negative impact on performance is often not noticeable unless the precision required by the system is very high, such as on the sub-micron level.

The present disclosure builds upon a realization that if heat can be moved away from the measurement region of a sensor in a good way, the performance of a contactless metrology system can be improved. To that end, a modified sensing device comprising a heat exchanger is provided, which can exchange heat between a measurement region of the sensing device to an outside of the measurement region. In some embodiments, when the sensing device is installed into an enclosed metrology system, it can be connected to the outside of the enclosed region, such that heat may be exchanged between the enclosed region and the outside.

One way that the performance of a sensing device may be improved is that the standard deviation between subsequent measurements may be reduced. During testing, it has been discovered that the standard deviation for high precision sensing devices may be improved from several microns down to below one micron. In some tests, the standard deviation without any heat exchanging performed was approximately 2,3 (two and three tenths) microns, and the standard deviation with heat exchanging using a sensing device as described herein was approximately 0,6 (six tenths) microns.

Although the above realization was based on noticing that too much heat had a negative impact on sensors of a contactless metrology system, the idea of exchanging heat can naturally be applied in the other directions as well. In other words, heat may be transported to the measurement region surrounding the sensing device rather than away from it, in case the temperature is lower than optimal for the system. Thus, the present disclosure is not only focused on moving heat away from a sensing device, but rather on controlling the temperature in the measurement region surrounding a sensing device.

It may also be the case that it's not the temperature of the sensors and/or of the metrology system itself that is the main problem, but rather the temperature gradient between the laser and/or sensors and the ambient temperature of the metrology system. Thus, in some embodiments, the present disclosure may be seen as a method for decreasing the temperature gradient between a sensor and/or laser and/or sensing unit and the ambient air of a metrology system and/or the ambient temperature of the workpiece.

In testing which has been performed in connection with this invention, it has been shown that the temperature of the lasers and/or sensors used in the metrology system could be decreased from approximately 30 degrees Celsius down to approximately 15-20 degrees Celsius. The temperature inside of the metrology system could be controlled to maintain approximately 20 degrees Celsius, with less temperature gradients inside of the metrology system.

For the purpose of this disclosure, the term "contactless metrology system" is intended to denote a metrology system with the capacity to measure workpieces without physically contacting the workpieces with any mechanical parts.

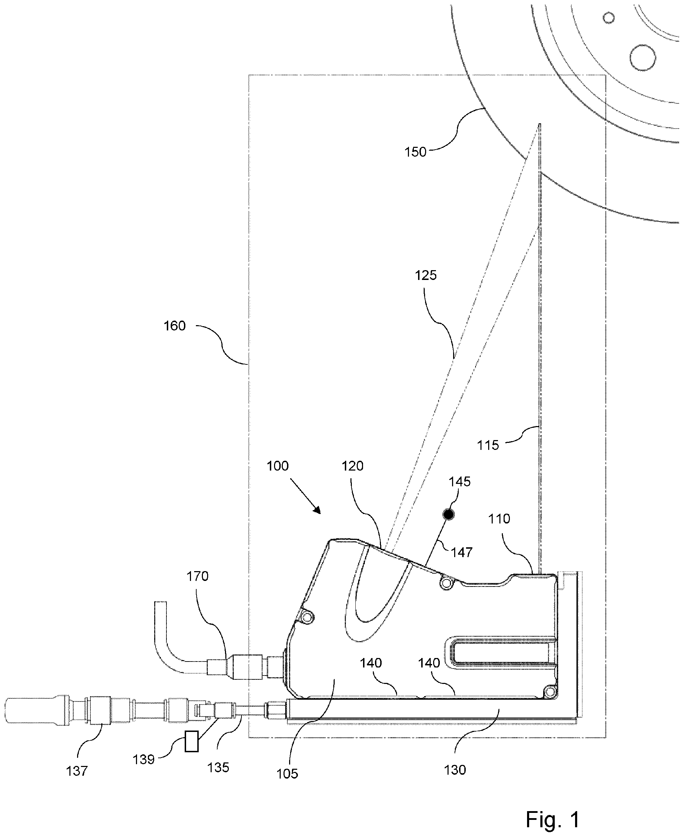

Looking now at Fig. 1, a sensing device 100 according to an embodiment is shown.

The sensing device 100 comprises a body 105. The body 105 comprises a light source 110 such as a laser, which may be a line laser. The light source 110 is adapted to emit a light beam 115 onto a workpiece 150, in order to measure the workpiece 150 with the help of a sensor 120 which is adapted to receive the light beam 115 after it has been reflected by the workpiece 150. The sensor 120 may be a camera with a field of view 125 aimed towards the part of the workpiece 150 that it is intended to measure. In some embodiments, the sensor 120 is a CMOS type sensor.

In some embodiments, the body comprises an enclosure for electronics and wiring associated with the components of the body, such as the sensor 120 and the light source 110. The heat generated by components of the sensing device, such as the sensor 120 and the light source, may be generated and/or contained in the body, to at least some degree.

The body 105 further comprises a heat exchanger 130, adapted to exchange heat from inside of a measurement are 160 to an outside of the measurement region 160. In some embodiments, the heat exchanger 130 is adapted to transfer heat from the body 105 into the heat exchanger 130, and then from the heat exchanger to an outside of the measurement region 160.

For the purpose of this disclosure, the measurement region 160 is intended to denote a region surrounding the sensor in which the sensor is negatively affected by temperature changes. The measurement region 160 is typically a volume, but in some embodiments it may be a two-dimensional area.

In embodiments where the sensing device 100 is positioned inside of a metrology system comprising an enclosure, the measurement region 160 may be a part of or the entire enclosure of the metrology system.

The body 105 may be made of any suitable material, preferably one that is relatively inexpensive and has a relatively high thermal conductivity, such as aluminum.

In some embodiments, the majority of the body 105 comprises a material which is not thermally conductive or at least has a very low thermal conductivity, while the parts of the body 105 which are facing the heat exchanger 130 comprise a thermally conductive material.

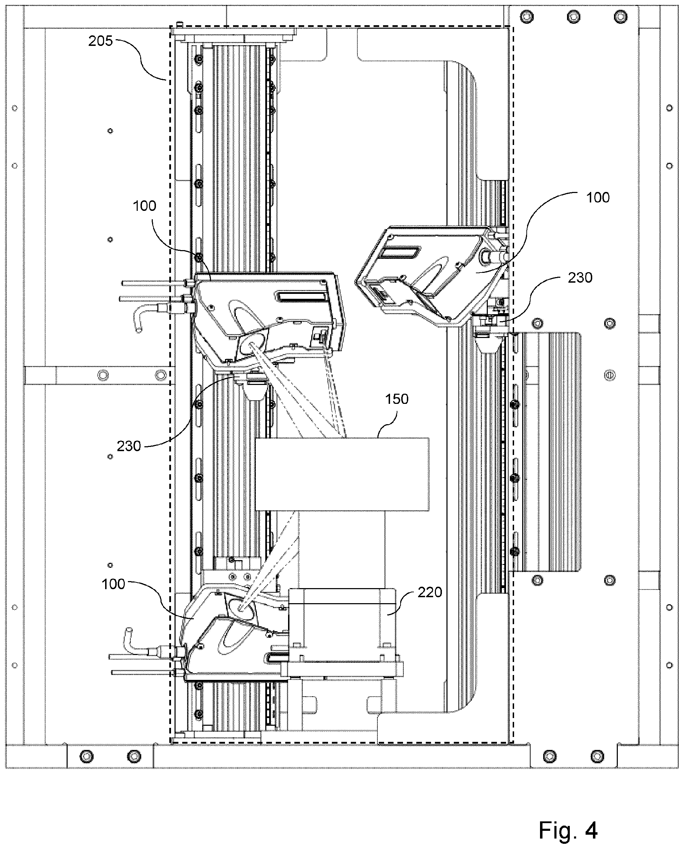

In some embodiments, the heat exchanger 130 may be a fluid heat exchanger comprising an inlet 135 and an outlet 137 (see, e.g., Fig. 4) for exchanging heat between the measurement region 160 and an outside of the measurement region 160. In some embodiments, the heat exchanger 130 may be a phase change heat exchanger. In some embodiments, the phase change heat exchanger may comprise liquid as a cooling fluid which changes phase to vapor during the heat exchanging process.

In some embodiments, the fluid in the heat exchanger 130 may be air. In some embodiments, the fluid may be a liquid, such as water, glycol or dielectric fluids. In some embodiments, the heat exchanger 130 further comprises a cooler or heater 139, positioned at the inlet 135 and adapted to cool or heat a heat exchanger fluid before it enters the inlet of the heat exchanger. In some embodiments, the cooler 139 is a vortex tube.

In some embodiments, the heat exchanger 130 comprises aluminum. In some embodiments, the heat exchanger 130 comprises copper. In some embodiments, the heat exchanger 130 comprises a plastic composite.

In some embodiments, the heat exchanger 130 may comprise a cooling channel 133 or multiple cooling channels, adapted to transport heat through the heat exchanger. In some embodiment, the heat exchanger may comprise one cooling channel with one end connected to the inlet 135 and one end connected to the outlet 137.

In some embodiments, the outlet 137 of the heat exchanger may be relatively long, in order for heat to be transported relatively far away from the light 110 source and the sensor 120. In some embodiments, the outlet of the heat exchanger may be between 0,1 and 2 meters. In some embodiments, it may be approximately 1 meter.

In some embodiments, the sensing device 100 may further comprise a powder cord 170, adapted to connect the sensing device 100 to a power source.

In some embodiments, the sensing device 100 further comprises a temperature sensor 145, which may in some embodiments also be positioned on the body 105. In some embodiments, such as the one shown in Fig. 1, the temperature sensor 145 is positioned at a distance away from the body 105, but is still connected to the body 105 by connecting means 147.

In such embodiments, the temperature sensor is adapted to measure the temperature of the measurement region 160, and the temperature of the measurement region 160 of a sensing device 100 is thus defined as the temperature measured by the sensor associated with that sensing device 100.

In some embodiments, the sensing device 100 may further comprise one or multiple heat sinks 140 for facilitating the heat exchange performed by the heat exchanger. The heat sinks may comprise any suitable material for conducting heat, such as aluminum or copper.

In some embodiments, the heat exchanger 130 is attached to the body 105 of the sensing device, for example by use of brackets in the body 105. Such brackets may traditionally be intended to fasten the body 105 in a metrology system. In some embodiments, the heat exchanger 130 may be incorporated into the body 105 such that it is integral with the body 105.

In some embodiments, the sensing device 100 may further comprise brackets, adapted to be used for fastening the sensing device 130 in a metrology system. In embodiments wherein the heat exchanger is attached to the body 105 by brackets in the body 105, the heat exchanger 130 may comprise similar or the same type of brackets on the outside.

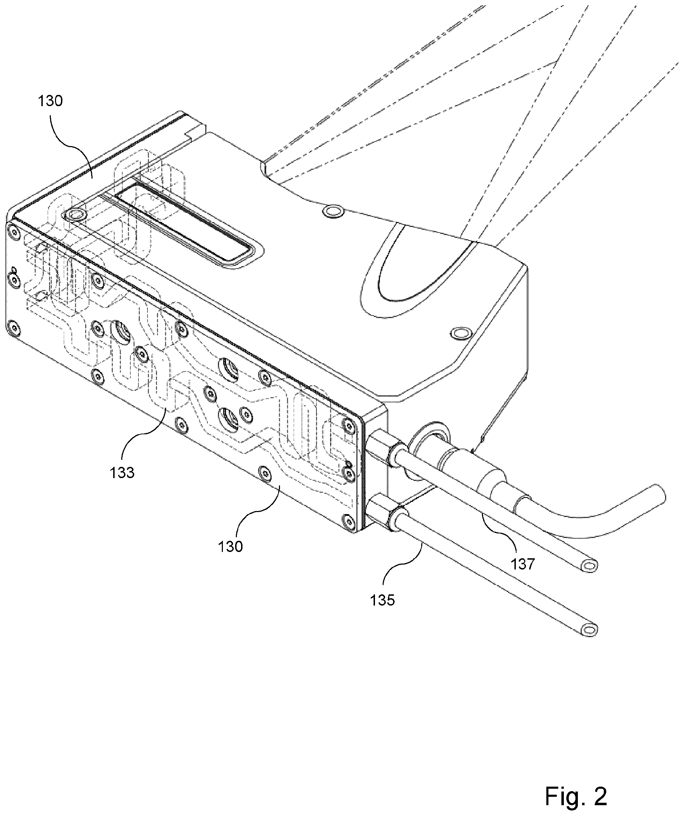

Looking now at Fig. 2, another view of the sensing device 100 is shown. In the embodiment shown in Fig. 2, the sensing device 100 comprises a cooling channel 133, contained inside of the heat exchanger 130. The cooling channel 133 is connected at one end to the inlet 135, and at one end to the outlet 137, and is adapted to transport heat through the heat exchanger 130. In some embodiments, such as the one shown in Fig. 2, the heat exchanger is positioned on two faces of the body 105, and has a L shape.

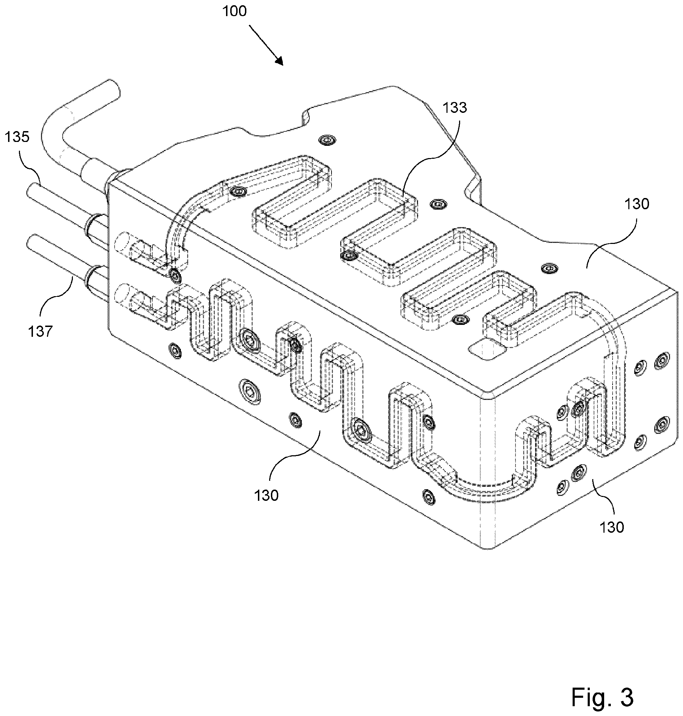

In some embodiments, such as the one shown in Fig. 3, the heat exchanger 130 is positioned on three faces of the body 105. In some embodiments, the heat exchanger may be positioned on four faces of the body 105, typically excluding the face where the light source 110 and sensor 120 are positioned, and the face where the inlet 135 and outlet 137 are positioned.

Looking now at Fig. 4, a metrology system 200 incorporating at least one sensing device 100 according to the present disclosure will now be described, with further reference to Fig. 1. Fig. 4 shows a cross-section of such a metrology system 200, comprising three sensing devices 100 according to embodiments described herein.

The metrology system 200, which is preferably a contactless metrology system, comprises an enclosure 205 (denoted by a dashed line), such as a cabinet, wherein the enclosure has a mechanism for opening and closing an entry to the enclosure, such as a door (not shown). The enclosure may further comprise walls or other barriers which separates an inside of the enclosure from an outside of the enclosure.

The metrology system 200 generally, but not necessarily, comprises other components as well, such as a stage 220 upon which a workpiece 150 can be positioned. The stage 220 may be a rotational stage, adapted to rotate such that the workpiece 150 is scanned by the sensing devices as it rotates or is moved by a linear translation stage.

The metrology system 200 may in some embodiments further comprise a cooling unit adapted to cool an inside of the enclosure 205. The cooling unit may be a piezoelectric cooling unit. The cooling unit may comprise one or multiple fans.

The system 200 may further comprise fixtures 230 onto which the sensing devices 100 are positioned and/or fastened. In some embodiments, the fixtures 230 are positioned on movable parts such that the sensing devices 100 can move around inside of the enclosure, such as movable arms. The sensing devices 100 may be attached to the fixtures 230 via brackets, positioned on either the sensing device body 105 or on the heat exchanger 130.

The system 200 further comprises at least one sensing device 100 according to any embodiment described herein, positioned inside of the enclosure 210. In some embodiments, such as the one shown in Fig. 4, the metrology system 200 comprises a plurality of sensing devices 100. In some embodiments, the metrology system 200 comprises at least two sensing devices 100.

In some embodiments, each sensing device 100 is associated with a respective measurement region. In some embodiments, the measurement region may be the same as the inside of the enclosure. In some embodiments, the temperature of a measurement region of a specific sensing device is defined as the temperature measured by a sensor associated with that sensing device.

In some embodiments, especially in embodiments wherein the sensing device 100 of the metrology system 200 does not comprise its own temperature sensor 145, the metrology system may comprise a temperature sensor for the sensing device. The temperature sensor for the sensing device may then be positioned at a distance from the sensing device 100, without being physically connected to the sensing device.

In some embodiments, the metrology further comprises a temperature detector, positioned inside the enclosure, adapted to measure a temperature of the enclosure. The temperature detector of the metrology system 200 may in some embodiments be used in conjunction with the temperature sensor(s) of the sensing device(s) or of the metrology system itself, which is elaborated on later in this disclosure.

By incorporating a sensing device inside of an enclosure 205 of a metrology system 200, the heat exchanger 130 of the sensing device may be connected to an outside of the enclosure 205 and heat may be exchanged from inside of the enclosure to the outside of the enclosure. In some embodiments, the enclosure is only partially enclosed from the outside of the metrology system. In some embodiments the enclosure is completely enclosed from the outside.

When working on the precision levels sometimes required by contactless metrology systems such as the system 200 described herein, there can be relevant advantages with exchanging heat between the inside the enclosure to an outside of the enclosure, rather than just exchanging heat from a region surrounding the laser 110 and/or sensor 120 of a sensing device to another region inside of the enclosure. In case heat is transported out of the enclosure 205, such heat is typically heat generated by the operation of the sensing device 105, and/or from other parts of the metrology system 205.

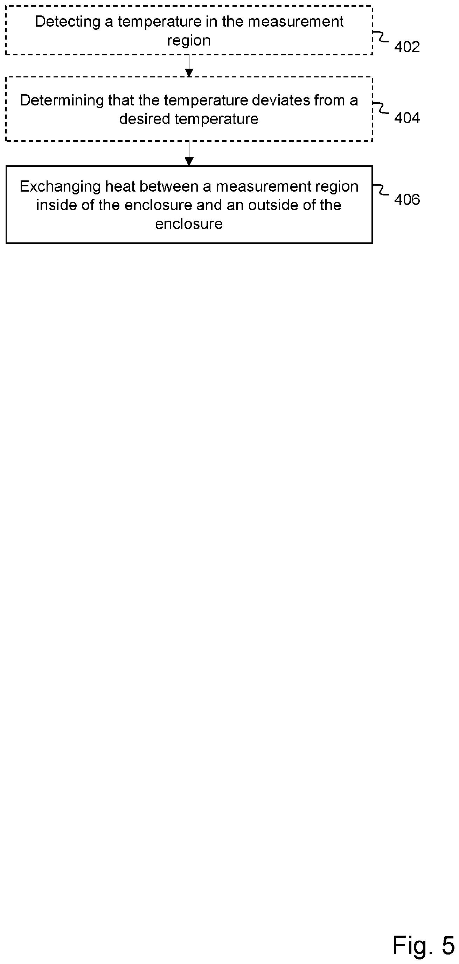

Looking now at Fig. 5, a method for improving the performance of a metrology system 200 according to the present disclosure will now be described, with further reference to Figs. 1 and 2. In some embodiments, the method may be a method for improving sensor performance in a metrology system 200. In some embodiments, the method may be a method for exchanging heat between a measurement region of a sensing device and an outside of the measurement region.

The method comprises, in a metrology system 200, exchanging 406 heat between the inside of the enclosure 205 to the outside of the enclosure 205. In some embodiments, the exchanging 406 comprises transferring heat from the inside of the enclosure 205 of the metrology system 200, to the outside of the enclosure 205. In some embodiments, the exchanging 406 comprises transferring heat from the outside of the enclosure 205 of the metrology system 200, to the inside of the enclosure 205. The exchanging 406 is performed such that there is no or at least no significant heat exchange from the heat transferred with the exchanger to the inside of the enclosure 205.

In embodiments wherein the heat exchanger 130 of the sensing device 100 is a fluid heat exchanger using air as fluid, the exchanging 406 comprises introducing a fluid into the heat exchanger, wherein the fluid is either heated or cooled before it is introduced into the heat exchanger depending on if the metrology system 200 is to be cooled or heated. The heating or cooling may be conducted by a cooler or heater 139 of the sensing device, wherein the cooler or heater 139 is positioned on an outside of the enclosure. The exchanging 406 then further comprises conducting the heat out of or into the enclosure by transporting the fluid through the heat exchanger.

As will be understood, if the method is performed in order to cool the metrology system 200, heat will be exchanged from inside of the enclosure to outside of the enclosure. If the method is performed in order to heat the metrology system 200, heat will be exchanged from outside the enclosure to the inside of the enclosure.

In some embodiments, the exchanging 406 may be preceded by detecting 402 a temperature in the measurement region 160 of the sensing device, and determining 404 that the detected temperature deviates from a desired temperature. Depending on if the detected temperature is lower or higher than a desired temperature, the exchanging will comprise exchanging heat either from or to the inside of the metrology system 200. The detecting 402 may be performed by either a temperature sensor of the sensing device 100 or a temperature detector of the metrology system 200.

In some embodiments, the method comprises constantly exchanging 406 heat between an inside of the enclosure and an outside of the enclosure, as long as the metrology system 200 and/or the sensing device 100 is powered.

In some embodiments, the detecting 402 may be performed by a temperature sensor of the sensing device as well as a temperature detector of the metrology system. In such embodiments, the detecting 402 may comprise detecting a first temperature with a temperature detector of the metrology system 200, and then comparing that with a second temperature detected by a temperature sensor of a sensing device 100. In case the first and second temperatures differ, that may be used as a determination that the temperature deviates from a desired temperature, in cases where it is important to have the same temperature everywhere inside of the metrology system 200.

In some embodiments, both the first and second temperatures may deviate from a desired temperature, wherein the desired temperature is known or determined prior to the detecting 402. Thus, in some embodiments, the method may first comprise a step of setting or determining a desired temperature, prior to the detecting 402.

In some embodiments, the sensing device 100 and/or the metrology system 200 may comprise processing circuitry and a memory. The processing circuitry may comprise one or more programmable processor, application-specific integrated circuits, field programmable gate arrays or combinations of these adapted to execute instructions. The memory contains instructions executable by said processing circuitry, whereby the sensing device and/or system is operable to perform the method according to any embodiment described herein.

The part of the sensing device 100 and/or metrology system 200 that performs the method may be a group of devices, wherein functionality for performing the method are spread out over different physical, or virtual, devices of the system. In other words it may be a cloud-solution, i.e. parts of the device/system may be deployed as cloud computing resources that may be distributed in the system.

According to other embodiments, the device and/or system may further comprise a communication unit, which may be considered to comprise conventional means for communicating with relevant devices. The instructions executable by said processing circuitry may be arranged as a computer program stored e.g. in the memory. The processing circuitry and the memory may be arranged in a sub-arrangement. The sub-arrangement may be a micro-processor and adequate software and storage therefore, a Programmable Logic Device, PLD, or other electronic component(s)/processing circuit(s) configured to perform the methods mentioned above.

The computer program may comprise computer readable code means, which when run in a the sensing device 100 and/or metrology system 200 causes the device/system to perform the method steps described in any of the described embodiments. The computer program may be carried by a computer program product connectable to the processing circuitry. The computer program product may be the memory. The memory may be realized as for example a RAM (Random-access memory), ROM (Read-Only Memory) or an EEPROM (Electrical Erasable Programmable ROM). Further, the computer program may be carried by a separate computer-readable medium, such as a CD, DVD or flash memory, from which the program could be downloaded into the memory. Alternatively, the computer program may be stored on a server or any other entity connected to the device 100 and/or system 200. The computer program may then be downloaded from the server into the memory.

Although the description above contains a plurality of specificities, these should not be construed as limiting the scope of the concept described herein but as merely providing illustrations of some exemplifying embodiments of the described concept. It will be appreciated that the scope of the presently described concept fully encompasses other embodiments which may become obvious to those skilled in the art, and that the scope of the presently described concept is accordingly not to be limited. Reference to an element in the singular is not intended to mean "one and only one" unless explicitly so stated, but rather "one or more." All structural and functional equivalents to the elements of the above-described embodiments that are known to those of ordinary skill in the art are expressly incorporated herein by reference and are intended to be encompassed hereby. Moreover, it is not necessary for an apparatus or method to address each and every problem sought to be solved by the presently described concept, for it to be encompassed hereby. In the figures representing method steps, a broken line generally signifies that the feature within the broken line is optional.

## Claims

**1.** A sensing device (100) for a metrology system (200), the sensing device (100) having a measurement region (160) and comprising:
a body (105), the body (105) comprising:
at least one light source (110) adapted to emit a light onto a workpiece (150);
at least one sensor (120) adapted to receive light from the light source (110) after it has been reflected by the workpiece (150); and
at least one heat exchanger (130) comprising an inlet (135) and an outlet (137) for exchanging heat between the measurement region (160) and an outside of the measurement region (160).

**2.** The sensing device (100) according to claim 1, wherein the heat exchanger is a fluid heat exchanger.

**3.** The sensing device (100) according to claim 2, wherein the fluid is air.

**4.** The sensing device (100) according to claim 3, further comprising a temperature sensor for detecting the temperature in the measurement region (160) of the sensing device.

**5.** The sensing device (100) according to claim 4, further comprising a heat sink (140).

**6.** The sensing device (100) according to claim 5, wherein the heat exchanger (130) is attached to the body (105).

**7.** The sensing device (100) according to claim 6, wherein the heat exchanger is attached to the body via brackets of the sensing device (100), wherein the heat exchanger (130) comprises similar brackets.

**8.** The sensing device (100) according to claim 7, wherein the heat exchanger (130) is integrated into the body (105).

**9.** The sensing device (100) according to claim 8, wherein the heat exchanger (130) is located inside of the body (105).

**10.** A metrology system (200) for inspection of a three-dimensional workpiece, comprising:
an enclosure (205), comprising:
at least one sensing device (100) according to claim 1, wherein the heat exchanger (130) of the sensing device (100) is adapted to exchange heat between an inside the enclosure (205) and an outside of the enclosure (205).

**11.** The metrology system (200) according to claim 10, comprising at least two sensing devices (100) according to claim 1.

**12.** The metrology system (200) according to claim 11, further comprising a temperature sensor for each sensing device, located inside of the enclosure.

**13.** The metrology system (200) according to claim 12, further comprising a temperature detector for sensing a temperature of the metrology system inside of the enclosure (205).

**13.** A method for improving the performance of a metrology system (200) according to claim 10, wherein the method comprises:
exchanging (406) heat between a measurement region of a sensing device (100) inside of the enclosure (205), and an outside of the enclosure (210).

**14.** The method according to claim 13, wherein the method further comprises, prior to the exchanging:
detecting (402) a temperature in the measurement region; and
determining (404) that the temperature deviates from a desired temperature.

**15.** The method according to claim 14, wherein:
the heat exchanging is performed constantly when the light source is active.

**16.** The method according to claim 15, wherein the determining (404) is further based on a temperature detected by a temperature sensor of the metrology system.
